Europäisches Patentamt

European Patent Office

Office européen des brevets

(11) Veröffentlichungsnummer: **0 040 260**
**B1**

(12) EUROPÄISCHE PATENTSCHRIFT

(45) Veröffentlichungstag der Patentschrift:
**25.01.84**

(51) Int. Cl.³: **F 02 P 3/04**

(21) Anmeldenummer: **80105536.9**

(22) Anmeldetag: **16.09.80**

(54) **Transistor-Zündschaltung.**

(30) Priorität: **20.05.80 DE 3019162**

(43) Veröffentlichungstag der Anmeldung:
**25.11.81 Patentblatt 81/47**

(45) Bekanntmachung des Hinweises auf die Patenterteilung:
**25.01.84 Patentblatt 84/4**

(84) Benannte Vertragsstaaten:
**FR GB IT SE**

(56) Entgegenhaltungen:
**FR - A - 2 238 846**
**FR - A - 2 295 249**
**US - A - 3 710 131**

(73) Patentinhaber: **Licentia Patent-Verwaltungs-GmbH, Theodor-Stern-Kai 1, D-6000 Frankfurt/Main 70 (DE)**

(72) Erfinder: **Niemetz, Linhard, Fahrradstrasse 6, D-8500 Nürnberg (DE)**

(74) Vertreter: **Langer, Karl-Heinz, Dipl.-Ing. et al, Licentia Patent-Verwaltungs-GmbH Theodor-Stern-Kai 1, D-6000 Frankfurt/Main 70 (DE)**

## Transistorzündschaltung

Die Erfindung betrifft eine Transistorzündschaltung gemäss dem Oberbegriff des ersten Patentanspruchs.

Bei einer bekannten Transistorzündschaltung dieser Art (FR-A Nr. 2238846) ist in Serie mit der Primärwicklung einer Zündspule die Kollektoremitterstrecke eines Transistors geschaltet. Parallel zum Transistor liegt ein Spannungsteiler, der aus der Reihenschaltung von zwei ohmschen Widerständen gebildet ist. Zwischen dem Mittelpunkt des Spannungsteilers und der Basis eines weiteren Transistors liegt eine Zenerdiode, wobei die Basis dieses weiteren Transistors einen Schaltungseingang für Signale aus einer vorgeschalteten Impulsformerstufe bildet. Der weitere Transistor ist über eine Emitterkopplung mit der Basis des ersten Transistors verbunden. Bei dieser Anordnung wird über den Spannungsteiler ein Steuersignal über die Zenerdiode auf den Schaltungseingang zurückgeführt, das die am ersten Transistor auftretende, von der Zündspule verursachte Rückschlagspannung begrenzt. Es zeigt sich jedoch, dass bei so aufgebauten Transistorzündschaltungen die Rückschlagspannung temperaturabhängig ist. Die Begrenzung der Rückschlagspannung muss daher auf einen Wert eingestellt sein, der unter den ungünstigsten Bedingungen die am Transistor zulässige Grenzspannung nicht überschreitet.

Der Erfindung liegt die Aufgabe zugrunde, bei einer Transistorzündschaltung gemäss dem Oberbegriff des ersten Anspruchs Massnahmen zu treffen, durch welche die an der Primärwicklung der Zündspule auftretende Rückschlagspannung in einem weiten Temperaturbereich in engen Grenzen konstant gehalten wird.

Die Lösung dieser Aufgabe erfolgt gemäss der Erfindung durch die kennzeichnenden Merkmale des ersten Anspruchs.

Gemäss der Erfindung wird dem die Rückschlagspannung beeinflussenden Temperaturgang der Zenerdiode durch den Temperaturgang eines der Widerstände im Spannungsteiler entgegengewirkt. Dadurch wird die Rückschlagspannung in einem weiten Temperaturbereich auf einen relativ engen und konstanten Wert begrenzt.

Bei der Verwendung eines Schichtwiderstandes kann als Vorteil durch die Wahl der Dickschicht-Widerstandspaste mit dem gewünschten Widerstandswert und Temperaturgang eine Anpassung an den Temperaturgang der Zenerdiode erreicht werden. Dabei kann der mit dem Massenpotential verbundene Widerstand einstellbar sein, um die Rückschlagspannung den jeweiligen Werten des gewählten Transistors anpassen zu können. Daneben kann die Zenerdiode unmittelbar an die Basis des zu schützenden Transistors angeschaltet werden, so dass das zurückgeführte Begrenzungssignal ohne weitere zwischengeschaltete Bauelemente auf die Basis dieses Transistors wirkt.

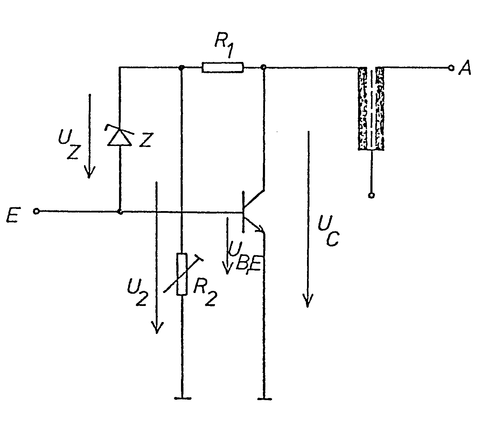

Ein Ausführungsbeispiel der Erfindung ist in der Zeichnung dargestellt:

Zwischen der Primärwicklung und dem Massenpotential ist ein Transistor zu einem ohmschen Spannungsteiler $R_1$, $R_2$ parallelgeschaltet, wobei der Widerstand $R_2$ zur Einstellung der Rückschlagspannungsbegrenzung dient. Zwischen der den Schaltungseingang E bildenden Basis des Transistors und dem Mittelpunkt des Spannungsteilers $R_1$, $R_2$ liegt die Zenerdiode Z. Wenn die am Widerstand $R_2$ abfallende Spannung $U_2$, die sich aus dem Teilerverhältnis $R_1$ zu $R_2$ und der Rückschlagspannung am Kollektor $U_C$ ergibt, die Zenerspannung $U_Z$ und die Spannung $U_{BE}$ überschreitet, wird die Zenerdiode leitend und steuert den Transistor durch, d.h. die Rückschlagspannung wird begrenzt. Durch den Temperaturkoeffizienten der Spannung der Zenerdiode ändert sich somit auch die Rückschlagspannung am Kollektor $U_C$. Um diese Änderung der Rückschlagspannung zu vermeiden, wird der Temperaturkoeffizient des Widerstandes $R_1$ oder des Widerstandes $R_2$ derart gewählt, dass die Zenerspannung $U_Z$ über einen weiteren Bereich temperaturkompensiert und die Rückschlagspannung über einen weiten Temperaturbereich eng begrenzt wird.

Bei einem Ausführungsbeispiel soll die Kollektorspannung $U_C$ zwischen 360 V und 385 V im Temperaturbereich zwischen −28 und +115°C liegen. Bei Wahl des Transistors mit $U_{BE}=2$ V und einer Zenerdiode mit $U_Z=150$ V ergibt sich bei

$$U_C = U_2\left(1 + \frac{R_1}{R_2}\right)$$

das Teilerverhältnis

$$\frac{R_1}{R_2} = \frac{U_C}{U_2} - 1 = \frac{370}{152} - 1 = 1{,}43$$

Ohne Berücksichtigung eines Temperaturganges des Spannungsteilers errechnet sich der Temperaturkoeffizient der Zenerdiode zu

$$TK_Z = \frac{U_C}{U_Z \cdot \left(1 + \dfrac{R_1}{R_2}\right)} \cdot \frac{1}{\Delta\vartheta}$$

$$= \frac{(385 - 360)}{150 \cdot 2{,}43} \cdot \frac{1}{(115 + 28)}$$

$$TK_Z = + 4{,}8 \cdot 10^{-4} \, K^{-1}$$

Der Temperaturkoeffizient einer handelsüblichen 150 V Zenerdiode liegt jedoch bei $(+9$ bis $+13) \cdot 10^{-4} \, K^{-1}$, so dass der Temperaturkoeffizient des Spannungsteilers berücksichtigt werden muss, um zu einem geforderten Spannungsbereich zwischen 360 V und 385 V zu gelangen.

Mit einer Zenerdiode $U_Z=150$ V und $T_{K,Z}= +9 \cdot 10^{-4} \, K^{-1}$ und einem Transistor mit $U_{B,E}=2$ V und $T_{K,BE}=-5 \cdot 10^{-3} \cdot K^{-1}$ gilt

$$\text{bei } \; 25\,°C\text{:} \; \frac{R_1}{R_2} = \frac{U_C}{U_2} - 1 = 1{,}43$$

bei 115 °C:

$$U_Z{}^{115} = 150\,(1 + 9 \cdot 10^{-4} \cdot 90) = 162{,}15\ V$$

$$U_{B,E}{}^{115} = 2\,(1 - 5 \cdot 10^{-3} \cdot 90) = 1{,}10\ V$$

$$U_2{}^{115} = U_Z{}^{115} + U_{B,E}{}^{115} = 163{,}25\ V$$

Erfindungsgemäss soll $U_C$ konstant sein, woraus folgt:

$$\frac{R_1{}^{115}}{R_2} = \frac{U_C}{U_2{}^{115}} - 1 = \frac{370}{163{,}25} - 1 = 1{,}266$$

Mit $R_2$ = konstant, ergibt sich $R_2{}^{25} = R_2{}^{115}$ und

$$\frac{\dfrac{R_1{}^{25}}{R_2{}^{25}}}{\dfrac{R_1{}^{115}}{R_2{}^{115}}} = \frac{1{,}43}{1{,}266} = \frac{R_1{}^{25}}{R_1{}^{115}}$$

$$R_1{}^{115} = R_1{}^{25} \cdot \frac{1{,}266}{1{,}43} = 0{,}885 \cdot R_1{}^{25}$$

$$= R_1{}^{25}\,(1 + T_{K,R} \cdot \Delta\vartheta)$$

$$\text{und } T_{K,R} = \frac{0{,}885 - 1}{90} = -13 \cdot 10^{-4}\ K^{-1}$$

Der Widerstand $R_1$ muss einen der Zenerdiode entgegengesetzten Temperaturkoeffizienten besitzen, bzw. der Widerstand $R_2$ einen konformen.

## Patentansprüche

1. Transistorzündschaltung mit einem Transistor zwischen der Primärwicklung einer Zündspule und dem Massenpotential, mit einem parallel zum Transistor geschalteten ohmschen Spannungsteiler ($R_1$, $R_2$) und mit einer Zenerdiode (Z), die zwischen dem Mittelpunkt des Spannungsteilers ($R_1$, $R_2$) und einem mit der Basis des Transistors verbundenen Schaltungseingang (E) liegt, dadurch gekennzeichnet, dass der mit der Primärwicklung verbundene Widerstand ($R_1$) des Spannungsteilers einen der Zenerdiode (Z) entgegengesetzten Temperaturkoeffizienten oder der mit dem Massenpotential verbundene Widerstand ($R_2$) einen zur Zenerdiode (Z) konformen Temperaturkoeffizienten aufweist, so dass der Temperaturgang der Zenerdiode kompensiert ist.

2. Transistorzündschaltung nach Anspruch 1, dadurch gekennzeichnet, dass der Spannungsteiler aus auf einen Trägerkörper aufgebrachten Dickschichtwiderständen ($R_1$) und ($R_2$) besteht.

3. Transistorzündschaltung nach einem der beiden Ansprüche 1 oder 2, dadurch gekennzeichnet, dass der mit dem Massenpotential verbundene Widerstand ($R_2$) einstellbar ist.

4. Transistorzündschaltung nach Anspruch 1 oder nach einem der folgenden, dadurch gekennzeichnet, dass die Zenerdiode (Z) unmittelbar an die Basis des Transistors angeschaltet ist.

## Claims

1. A transistor-ignition circuit with a transistor between the primary winding of an ignition coil and the earth potential, with an ohmic voltage divider ($R_1$, $R_2$) connected in parallel to the transistor and with a Zener diode (Z), which lies between the middle point of the voltage divider ($R_1$, $R_2$) and a circuit input (E) connected to the base of the transistor, characterized in that the resistor ($R_1$) of the voltage divider that is connected with the primary winding has a temperature coefficient opposing that of the Zener diode (Z) or that the resistor ($R_2$) connected to earth potential comprises a temperature coefficient conforming with that of the Zener diode (Z), so that the temperature movement of the Zener diode is compensated.

2. A transistor-ignition circuit according to claim 1, characterized in that the voltage divider consists of thick film resistors ($R_1$) and ($R_2$) formed on a supporting body.

3. A transistor-ignition circuit according to claim 1 or 2, characterized in that the resistor ($R_2$) connected to earth potential is adjustable.

4. A transistor-ignition circuit according to claim 1 or one of the following claims, characterized in that the Zener diode (Z) is directly connected to the base of the transistor.

## Revendications

1. Circuit d'allumage de transistor comprenant un transistor, intercalé entre l'enroulement primaire d'une bobine d'allumage et le potentiel de masse, un diviseur de tension ohmique ($R_1$, $R_2$), monté en parallèle avec le transistor, et une diode Zener (Z), intercalée entre le milieu du diviseur de tension ($R_1$, $R_2$) et une entrée de couplage (E) reliée à la base du transistor, caractérisé en ce que la résistance ($R_1$) du diviseur de tension qui est reliée à l'enroulement primaire a un coefficient de température opposé à celui de la diode Zener (Z) ou que la résistance ($R_2$) qui est reliée au potentiel de masse a un coefficient de température conforme à celui de la diode Zener (Z), de sorte que les variations de la diode Zener dues à la température sont compensées.

2. Circuit d'allumage de transistor selon la revendication 1, caractérisé en ce que le diviseur de tension est constitué par des résistances à couche épaisse ($R_1$) et ($R_2$) montées sur un support.

3. Circuit d'allumage de transistor selon l'une des revendications 1 ou 2, caractérisé en ce que la résistance ($R_2$) reliée au potentiel de masse est réglable.

4. Circuit d'allumage de transistor selon l'une des revendications 1 à 3, caractérisé en ce que la diode Zener (Z) est directement reliée à la base du transistor.

$R_1$

$A$

$U_Z$   $Z$

$E$

$U_{BE}$

$U_C$

$U_2$   $R_2$